Europäisches Patentamt

European Patent Office

Office européen des brevets

(11) Publication number: **0 484 799 A1**

# EUROPEAN PATENT APPLICATION

(21) Application number: **91118413.3**

(22) Date of filing: **29.10.91**

(51) Int. Cl.5: **E05C 19/04**

(30) Priority: **30.10.90 US 605675**

(43) Date of publication of application:
**13.05.92 Bulletin 92/20**

(84) Designated Contracting States:
**CH DE FR GB LI**

(71) Applicant: **THE CURRAN COMPANY**
**400 High Grove Boulevard**
**Glendale Heights, Illinois 60139(US)**

(72) Inventor: **Curran, William E.**
**6N 312 Glendale**
**Medinah, Illinois 60157(US)**
Inventor: **Weibler, Joseph C.**
**29 W. 170 Donald Avenue**
**West Chicago, Illinois 60185(US)**
Inventor: **Egan, Michael T.**
**218 Traver Street**
**Glen Ellyn, Illinois 60137(US)**

(74) Representative: **Bauer, Robert, Dipl.-Ing. et al**
**Boeters & Bauer Patentanwälte**
**Bereiteranger 15**
**W-8000 München 90(DE)**

(54) **Door latch system for EMI shielded room.**

(57) The walls of a shielded room and a door in a wall have EMI shielding layers. A door gap seal connects the wall seal and door seal and prevents EMI leakage when the door is closed. Sturdy handles fixed to the door surfaces permit significant forces to be applied for opening and closing the door without causing failure. The door is releasably latched in the closed position by a self latching system that is independent of the handles and that is not subjected to door closing or opening forces. The latch system includes a spring biased roller catch mounted in a mortise in the door and engageable with a recess in a strike plate in the door jamb.

FIG-1

## Field of the Invention

The present invention relates to electromagnetic interference (EMI) shielded enclosures, and more particularly to an improved latch system for a door of a shielded room.

## Description of the Prior Art

Shielded enclosures are used to attenuate interference for many purposes. The walls of a shielded enclosure are typically provided with at least a single layer of EMI shielding material such as conductive metal sheet or screen. Shielding systems used with enclosures and rooms can be used to confine radio frequency and magnetic interference within a protected enclosure, and can be used to protect the interior of the shielded enclosure from externally generated interference.

In an EMI shielded room, a door is usually provided to permit ingress and egress. In order to maintain the integrity of the shielding system at the doorway, the door includes at least one layer of shielding material, and a gap seal is often used to provide shielding between the door and door frame and to connect the door shield to the wall shield when the door is closed. Door gap seals typically are frictionally engaged between the door and frame, and can increase the force required to open and shut the door. In many installations, such as shielded rooms for commercial and industrial installations, door closing and latching systems having massive and sturdy lever and cam arrangements can be used and increased door closing and opening forces do not cause substantial problems.

Shielded rooms are increasingly used for medical and diagnostic equipment such as magnetic resonance imaging (MRI) installations. Rooms of this type are normally found in a hospital, medical center or similar environment where the appearance of the structure is important. It is desirable for the room and the door to the room to have an appearance that does not unnecessarily contribute to patient anxiety. It is also desirable that the door be capable of being opened and closed easily without massive and difficult to operate mechanisms. For these reasons, lever and cam door latching systems are not considered suitable for many medical applications.

In order to provide a more normal appearance, conventional mortise lock sets have been used to latch the doors of shielded rooms in medical applications. This type of latch system includes a latch mechanism received in an opening or mortise in the door edge cooperating with an aperture in a strike plate in the door jamb. An operating shaft extends through both faces of the door and handles or knobs are attached to the shaft both inside and outside of the room.

With this conventional construction, when the door is fully closed, the latch is urged by a biasing spring to enter the strike plate aperture and the door is positively latched shut. In order to open the door, either one of the handles is turned to rotate the operating shaft. The shaft in turn operates a cam mechanism within the door to withdraw the latch member from the strike plate aperture and free the door so that it can be opened.

Because of the specific requirements and characteristics of a shielded room for MRI apparatus and the like, this conventional door latching system has been subject to serious, long standing problems. One problem is that the door latch operating apparatus must project through the EMI shielding layer or layers of the door. The operating shaft extends between, through and beyond both faces of the door and a handle is mounted on both ends of the shaft. Any penetration of the continuous shielding layer can result in impairment of the shielding effectiveness and therefore should be avoided if possible. The problem can be particularly severe with a conventional lock set because the conductive metal shaft and projecting handles can act like an antenna, coupling undesired EMI signals through the door shield. Even if leakage is minimized in the initial installation, wear of parts of the mechanism can cause the operating shaft to become loose and leakage increases.

Other problems result from the forces required to open and close the door. Not only is an EMI shielded door heavy but also the frictional forces encountered with the door gap seal add to the door operating forces. The forces can be increased if the gap seal is not installed and maintained correctly. With a conventional mortise lock set, often the only way to close or open the door is by pushing and/or pulling and/or turning one of the door handles. The door moving force is applied from the handle to the door through the operating shaft and other components of the lock set. Even if the door is opened and closed without using the handles, large forces can be applied to the lock set components as the door is latched and unlatched.

Large forces applied to the handles and other elements of the lock set can damage the lock set. This can lead to the necessity for regular inspection, repair and replacement of the lock set, and can lead to even more serious consequences. For example, during medical procedures, emergency or crisis situations can arise when the door of a shielded room must be opened immediately. It is under just such circumstances that excessive force may be exerted on a door handle. The lock set can fail due to breakage or jamming of delicate parts inside the door mortise, disabling the door latch in the door locked position. With a mortise lock set, the latch prevents the door from being opened by pushing or pulling until the latch is retracted from the strike plate aperture. Thus, with the conventional latch system, there is a possibility that the latch can fail with the door locked closed and the door cannot be opened in an emergency.

Situations can arise when it is necessary for a patient to be moved immediately from a shielded room. If the door latch mechanism fails in a locked condition, the door cannot be opened for removal of the patient. Although the severity of this problem has been recognized, the solutions that have been proposed have not been satisfactory. For example, one suggestion has been to provide the shielded room with a window that can be broken or removed to permit access to the interior of the room in the event that the latch system fails. This proposed solution involves difficulty and expense.

## Summary of the Invention

A primary object of the present invention is to provide a latch system for shielded rooms that cannot fail and leave the door in a locked condition such that it cannot be opened in an emergency. Among the other objects of this invention are to provide a latch system that is not subjected to large door opening or closing forces despite the door weight and the door gap seal operation; to provide a latch system that minimizes the possibility of EMI leakage through the door; to provide a latch system that does not interfere with or detract from the appearance of the walls and door of a shielded room; to provide a latch system that does not rely on manipulation of handles to unlatch the door; to provide a latch system characterized by a simple push-pull operation; and to provide a shielded room with a door latch system that overcomes problems with latch systems that have been used in the past.

In brief, an EMI shielded room in accordance with the present invention includes a wall with a continuous electrically conductive EMI wall shield layer defining an enclosed region shielded from an external region. A door frame including a jamb in the wall defines a doorway for access to the enclosed region. A door is moveably mounted in the doorway for movement between open and closed positions. The door has opposed inner and outer door faces, an edge extending between the faces and an EMI door shield layer on at least one of the door faces. A gap is defined between the door jamb and the door edge in the closed position of the door and an EMI shielding gap seal in the gap engages both the door edge and the door jamb in the closed position of the door. A latch system for holding the door in the closed position includes a first latch element disposed at the jamb and a second latch element mounted at the door edge and engageable with the first latch element in the door closed position. The second latch element is located entirely between the planes of the door faces and does not extend through the EMI door shield layer.

## Brief Description of the Drawings

The present invention together with the above and other objects and advantages may best appear from the following detailed description of the embodiment of the invention illustrated in the accompanying drawings, wherein:

FIG. 1 is an elevational view of a part of an EMI shielded room including a door provided with a latch system according to the present invention;

FIG. 2 is an enlarged sectional view taken along the lin 2-2 of FIG. 1;

FIG. 3 is an enlarged sectional view taken along the line 3-3 of FIG. 1; and

FIG. 4 is a sectional view taken along the line 4-4 of FIG. 3.

## Detailed Description of the Illustrated Embodiment

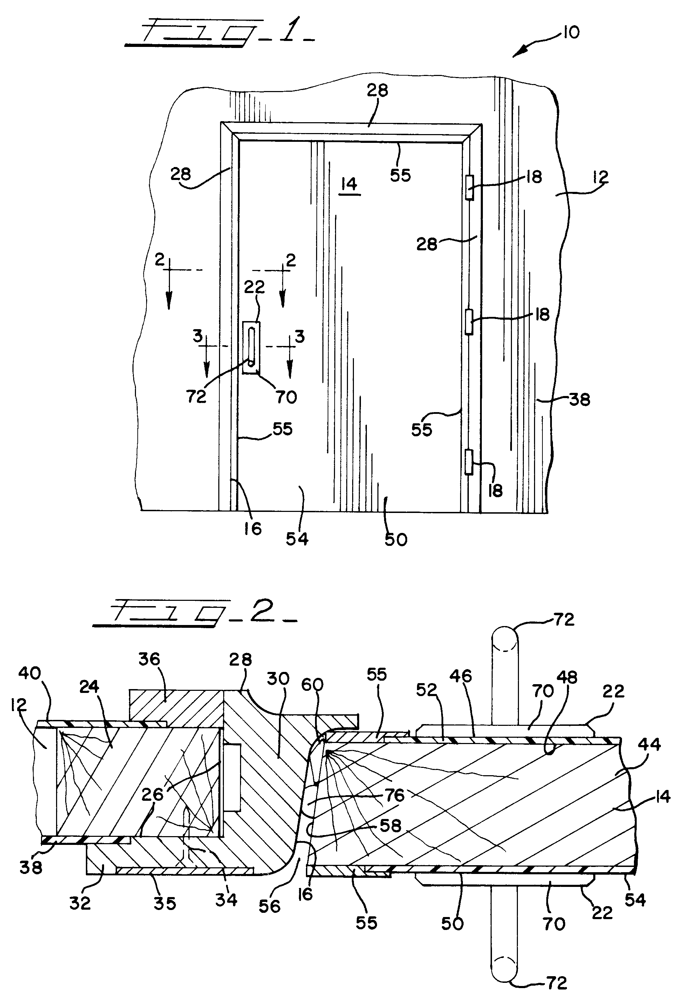

Having reference now to the drawings and initially to FIG. 1, there is shown a part of an EMI shielded room 10 including a wall 12 and a door 14 in a doorway 16. Although only a fragment of the wall 12 is seen, it should be understood that the room or enclosure 10 is surrounded by walls, a floor and a ceiling, all of which are constructed to prevent or reduce the passage of EMI such as radio frequency radiation. The room 10 therefore encloses an interior region that is shielded from electromagnetic interference originating outside of the room and, in the same way, the exterior of the room is shielded from electromagnetic interference that originates within of the room.

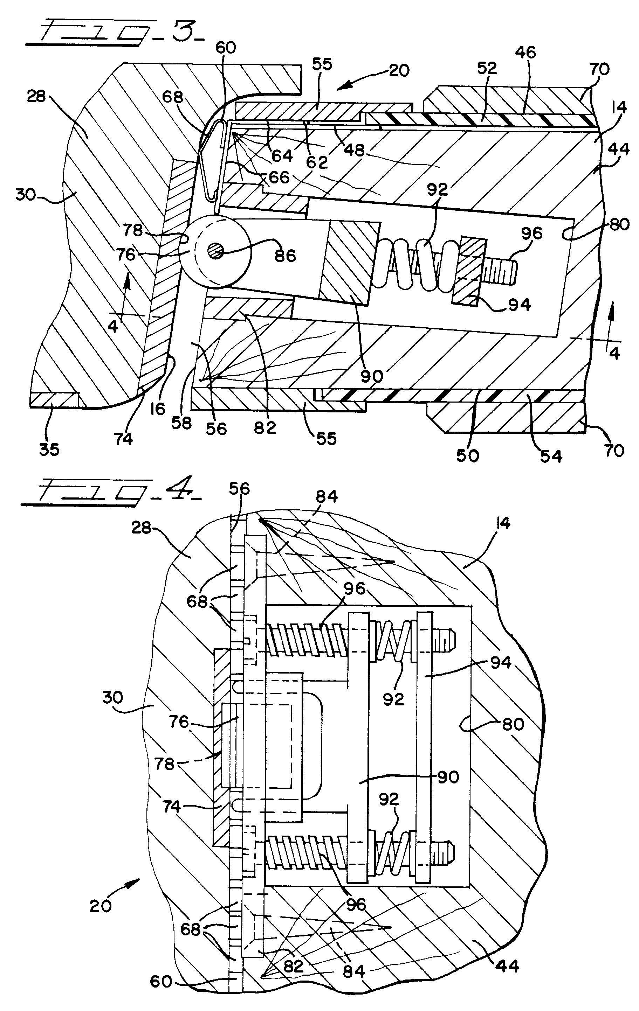

Door 14 permits entry into the room 10 and is movable between the closed position illustrated in the drawings and an open position. The door 14 is suspended within the doorway 16 by hinges 18 permitting the door to pivot between its positions. In accordance with the present invention, the door 14 is provided with a latch system generally designated as 20 best seen in FIGS. 3 and 4. Handle assemblies 22 independent of latch system 20 are used to open and to close the door 14.

Principles of the present invention can be applied to shielded rooms having many types of structures and shielding systems. In the illustrated arrangement, the wall 12 includes structural frame members of wood, such as the door frame member 24 seen in FIG. 2. Similar door frame members are at the opposite side and top of the doorway 16 and surround the door 14. Wall 12 includes a continuous layer 26 of EMI shielding material in the form of a thin sheet or foil of copper. Other materials such as screen or sheets of other metal could be used. Layer 26 entirely covers one surface of the wall 12. If desired, depending upon the shielding requirements, a second shielding layer could be employed on the opposite surface of the wall to increase the shielding effect. Typically, the wall, floor and ceiling shielding layer or layers are continuous around the entire room 10, are electrically connected to one another, and are connected to ground at a single point.

Doorway 16 is surrounded by a jamb 28 having an interior portion 30 extending through the doorway 16 and a trim flange portion 32 attached to the door frame 24 by fasteners 34 concealed behind a cover strip 35. Jamb 28 is made of an electrically conductive metal such as brass or aluminum, and intimately contacts the shield 26 at one face and at the inner edge of the door frame 24. As a result the jamb 28 functions as a continuation of the room shielding system. A trim piece 36 may be used at the side of the wall 12 opposite the trim flange 32. The opposed surfaces of the wall 12 are provided with a finished appearance by surface layers 38 and 40 of a plastic laminate or the like. Layers 38 and 40 also strengthen the wall 12, and the layer 38 overlies and protects the shield layer 26.

Door 14 includes a core 44 that may be made of a wood frame with various other materials, or of other conventional materials. The inner face 46 of the door is provided with a continuous layer 48 of EMI shielding material that may be the same as the layer 26 or may be a different material. The outer face 50 of the door may also include an EMI shielding layer if desired. Sheets 52 and 54 of material such as a plastic laminate cover the door faces 46 and 50. The edge portions of the door faces 46 and 50 are finished with edge trim moldings 55.

A gap 56 is present around the door 14 due to the clearance between the door edge 58 and the portion 30 of the jamb 28. A gap seal 60 is used to prevent EMI leakage through the gap 56 by interconnecting the wall shield layer 26 and the door shield layer 48 continuously around the door 14. Although various types of gap shields may be used, the preferred gap seal 60 is of the type disclosed in detail in U.S. patent No. 4,786,758 dated November 22, 1988 incorporated by reference herein. This seal includes a base portion 62 with one flange 64 overlying the inner door face 46 where it is in intimate and continuous engagement with the door shield layer 48. A second flange 66 overlies the door edge 58. A finger assembly includes numerous fingers 68 each having one end fixed to the base 62 and another end that is slideable on the flange 66. The intermediate part of each finger 68 acts as a contact that engages the electrically conductive jamb 28 when the door is closed. The gap seal is preferably used around the entire periphery of the door 14 and engages the floor of the room 10 as well as the jamb 28.

When the door 24 is closed in the doorway 16, each of the fingers 68 engages and is flexed by engagement with the portion 30 of jamb 28. The compliance of the fingers assures good, continuous electrical contact with minimum force requirements. Nevertheless, the total force required to close the door, including the force required to flex each finger 68, can be significant. Because of the static friction of each finger 68 against the jamb 28 when the door is stationary in the closed position, the force required to move the door 14 from the closed position toward the open position can also be significant.

Handle assemblies 22 secured to the inner and outer door faces 46 and 50 are used to open and close the door 14. Each handle assembly 22 is mounted to the surface of the door, and requires no moving parts. In the preferred illustrated arrangement, both handle assemblies include a surface mounting plate 70 and a rigid, U-shaped handle 72 fixed to the plate 70. To open the door 14, the inner handle 72 is pushed or the outer handle 72 is pulled. To close the door 14 the outer handle 72 is pushed or the inner handle 72 is pulled. The handles assemblies are used only to push and pull the door and are not otherwise required to effect of assist the operation of the latch system 20. The handle assemblies are strong and rigid and ample force can easily be applied to the door 14 without subjecting any delicate mechanism to that force.

Latch system 20 serves to releasably hold the door 14 in the illustrated closed position while preventing a condition in which the door 14 cannot be opened. In general, the latch system 20 includes a first latch element 74 and a second latch element 76. These elements are self latching to secure the door without requiring any manipulation other than moving the door 14 to its closed position. Similarly, these latch elements are self unlatching to release the door without requiring any manipulation other than moving the door away from its closed position.

In the preferred arrangement, element 74 is a strike plate having a latch recess or aperture 78 and element 76 is a catch roller that is received into the recess 78 when the door is closed. If desired, the latch plate can be omitted, and the recess 78 can be provided in the jamb 28 itself. If desired a spring loaded ball could be used in place of the roller 76. Although a single latch system 20 is used with the door 14, more than one could be used in order to more evenly apply the latch force to the door. The latch system 20 does not include components that extend through the door shield layer 48 or components that project from the opposed faces of the door.

With reference to FIGS. 3 and 4, the strike plate is inset into and attached to the jamb 28. The roller 76 is part of a mechanism that is mounted in a mortise 80 in the edge 58 of the door 14. Alternatively, the latch recess 78 could be formed on or in the door and the roller 76 could be mounted in the door jamb or frame. A mounting base 82 is attached to the door core 44 by fasteners 84. Roller 76 rotates on an axle pin 86 supported by an adjustable frame 90. Springs 92 compressed between frame 90 and a reaction plate 94 bias the roller 76 outward toward the strike plate 74 and recess 78 and permit the roller 76 to move inward as the door is closed or opened. Adjustment screws 96 cooperate with the frame 90 and plate 94 to adjust the position of and the spring force applied to the roller 76.

Because the latch system 20 of the illustrated arrangement is not exposed at either face of the door 14, it does not adversely affect the appearance of the installation. However, the latch system could be incorporated into structure mounted at the door and wall surface, and this may be the preferred way to retrofit a latch system 20 onto a previously installed door. The latch system operates independently of the handle assemblies 22, and is not subjected to door opening or closing forces. Thus the system 20 permits a simple push-pull operation that is not prone to failure and, even in the unlikely event of failure, the door 14 can be pushed or pulled open because no failure mode prevents the roller 76 from being cammed out of the recess 78 as the door opens.

While the invention has been described with reference to details of the illustrated embodiment, these details are not intended to limit the scope of the invention as defined in the appended claims.

## Claims

1. An EMI shielded room comprising in combination:

   wall means including a continuous electrically conductive EMI wall shield layer defining an enclosed region shielded from an external region;

   a door frame including a jamb in said wall means defining a doorway in said wall means for ingress and egress to and from said enclosed region;

   a door moveably mounted in said doorway for movement between open and closed positions;

   said door having opposed inner and outer door faces and having an edge extending between said faces;

   an EMI door shield layer on at least one of said door faces;

   a gap defined between said door jamb and said door edge in the closed position of said door;

   door operating means for applying door closing or door opening forces to said door;

   a EMI shielding gap seal in said gap and engaging both said door edge and said door jamb in the closed position of said door; and

   a latch system for holding said door in the closed position;

   said EMI shielded room being characterized by:

   said latch system including a first latch element disposed at said jamb and a second latch element mounted at said door edge and engageable with said first latch element in the door closed position; and

   said first and second latch elements being independent of said door operating means.

2. An EMI shielded room as claimed in claim 1 wherein said second latch element is disposed entirely between the planes of said door faces and does not extend through said EMI door shield layer.

3. An EMI shielded room as claimed in claim 1 wherein said first and second latch elements are frictionally self latching and self unlatching in response to movement of said door to and from the closed position.

4. An EMI shielded room as claimed in claim 3, said second latch element comprising part of a latching mechanism mounted in a mortise within said door between said door faces.

5. An EMI shielded room as claimed in claim 4, said first latch element comprising a strike plate with an indent on said jamb, and said latching mechanism including spring means biasing said second latch element into engagement with said strike plate in the closed position of said door.

6. An EMI shielded room as claimed in claim 5, said second latch element comprising a latch roller engageable with the indent in said strike plate.

7. An EMI shielded room as claimed in claim 1, further comprising hinges mounting said door to said frame at an edge of said door opposite to said latch elements.

8. An EMI shielded room as claimed in claim 1, said EMI shielding gap seal including a base electrically connected to said EMI door shielding layer and an array of flexible electrical conductive fingers disposed in said gap.

9. An EMI shielded room as claimed in claim 8, said jamb comprising an electrically conductive body electrically connected to said EMI wall shield layer, said electrically conductive fingers frictionally engaging said jamb in the door closed position.

10. An EMI shielded room as claimed in claim 9, a segment of said EMI shielding gap seal and said second latch element being located beside one another at said door edge between the planes of said opposed door faces.

11. An EMI shielded room as claimed in claim 1, said door operating means comprising a surface mounted handle fixed to one face of said door.

12. An EMI shielded room as claimed in claim 1, said door operating means comprising a pair of surface mounted handles, one fixed to each opposed face of said door.

13. An EMI shielded room comprising in combination:

wall means including an electrically conductive EMI wall shield layer defining an enclosed region shielded from an external region;

frame means in said wall means defining a doorway in said wall means for access to said enclosed region;

a door moveably mounted in said doorway for movement between open and closed positions;

said door including an electrically conductive EMI door shield layer;

a gap defined in said doorway between said door and said frame means in the closed position of said door;

a EMI shielding gap seal in said gap and engaging both said door and said frame means in the closed position of said door;

handle means for the application of door opening and closing forces to said door; and

latch means for retaining said door in the closed position;

said EMI shielded room being characterized by:

said handle means including at least one handle fixed to said door;

said latch means including a pair of latch members carried by said door and said frame means, said pair of latch members including a first latch member defining a latch recess and a second latch member flexibly biased toward said recess in said closed position of said door for self latching and self unlatching operation in response to movement of said door to and from said closed position.

FIG-1

FIG-2

_FIG_-3-

_FIG_-4-

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 247 312 (ALESSI) | 1,11 | E05C19/04 |
| A | * column 2, line 60 - column 3, line 6; claim 1; figures 1,7-9 * | 7,13 | |
| | --- | | |
| D,Y | US-A-4 786 758 (ZIELINSKI) | 1-10,13 | |
| | * column 2, line 31 - line 39 * | | |
| | * column 1, line 63 - column 2, line 4; figures 1,4 * | | |
| | --- | | |
| Y | US-A-3 031 220 (REISS) | 1-10,13 | |
| | * column 1, line 45 - line 70; claim 1; figure 1 * | | |
| | --- | | |
| A | US-A-2 184 879 (WOERNLE) | 1-6,13 | |
| | * column 1, line 38 - column 2, line 7 * | | |
| | * column 2, line 37 - line 41; figures * | | |
| | --- | | |
| A | DE-C-3 916 836 (ABS ALLGEMEINER BRANDSCHUTZ) | 1,11-13 | |
| | * column 3, line 8 - line 28; figure 2 * | | |
| | ----- | | TECHNICAL FIELDS SEARCHED (Int. Cl.5) |
| | | | E05C H05K |

The present search report has been drawn up for all claims

| Place of search | Date of completion of the search | Examiner |
|---|---|---|
| THE HAGUE | 12 MARCH 1992 | RUBENOWITZ A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)